(19)

Europäisches
Patentamt
European
Patent Office
Office européen
des brevets

(11) **EP 3 649 568 B1**

(12) **EUROPEAN PATENT SPECIFICATION**

(45) Date of publication and mention
of the grant of the patent:
**01.05.2024 Bulletin 2024/18**

(21) Application number: **18735581.3**

(22) Date of filing: **03.07.2018**

(51) International Patent Classification (IPC):
***G06F 17/18*** *(2006.01)*

(52) Cooperative Patent Classification (CPC):
**G06F 17/18**

(86) International application number:
**PCT/EP2018/067972**

(87) International publication number:
**WO 2019/007970 (10.01.2019 Gazette 2019/02)**

(54) **METHOD FOR AUTOMATIC DETECTION OF PHYSICAL MODES IN A MODAL ANALYSIS MODEL**

VERFAHREN ZUR AUTOMATISCHEN DETEKTION VON PHYSIKALISCHEN MODI IN EINEM
MODALANALYSEMODELL

PROCÉDÉ DE DÉTECTION AUTOMATIQUE DE MODES PHYSIQUES DANS UN MODÈLE
D'ANALYSE MODAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.07.2017 EP 17179576**

(43) Date of publication of application:
**13.05.2020 Bulletin 2020/20**

(73) Proprietor: **Vrije Universiteit Brussel**
**1050 Brussel (BE)**

(72) Inventors:
• **HELSEN, Jan**
**8301 Knokke-Heist (BE)**
• **GUILLAUME, Patrick**
**1050 Brussels (BE)**
• **GIOIA, Nicoletta**
**20090 Rodano (Milano) (IT)**

(74) Representative: **AWA Benelux**
**AWA Benelux SA**
**Tour & Taxis - Royal Depot box:216**
**Havenlaan 86c Avenue du Port**
**1000 Bruxelles (BE)**

(56) References cited:
• **NEU EUGEN ET AL: "Fully Automated
Operational Modal Analysis using multi-stage
clustering", MECHANICAL SYSTEMS AND
SIGNAL PROCESSING, ELSEVIER,
AMSTERDAM, NL, vol. 84, 26 July 2016
(2016-07-26), pages 308-323, XP029752673, ISSN:
0888-3270, DOI: 10.1016/J.YMSSP.2016.07.031**
• **S. F. GHAHARI ET AL: "Blind modal identification
of structures from spatially sparse seismic
response signals : BLIND MODAL
IDENTIFICATION FROM SPARSE SEISMIC
RESPONSE SIGNALS", STRUCTURAL
CONTROL AND HEALTH MONITORING, vol. 21,
no. 5, 16 August 2013 (2013-08-16), pages
649-674, XP055439054, US ISSN: 1545-2255, DOI:
10.1002/stc.1593**
• **E. MRABET ET AL: "A New Criterion for the
Stabilization Diagram Used with Stochastic
Subspace Identification Methods: An Application
to an Aircraft Skeleton", SHOCK AND
VIBRATION, vol. 2014, 17 March 2014
(2014-03-17), pages 1-8, XP055439102, NL ISSN:
1070-9622, DOI: 10.1155/2014/409298**

EP 3 649 568 B1

**(Cont. next page)**

- **HSU WEI-TING ET AL: "Uncertainty calculation for modal parameters used with stochastic subspace identification: an application to a bridge structure", VISUAL COMMUNICATIONS AND IMAGE PROCESSING; 20-1-2004 - 20-1-2004; SAN JOSE,, vol. 9435, 27 March 2015 (2015-03-27), pages 94350Q-94350Q, XP060052419, DOI: 10.1117/12.2083919 ISBN: 978-1-62841-730-2**

## Description

### Field of the invention

This invention relates to modal analysis and to the automatic selection of physical vibration modes of the system under investigation, in order to distinguish these modes from mathematical modes. The invention is also related to signal processing, in particular to the treatment of a signal in the time domain and/or in the frequency domain.

### Background of the invention

The data obtained from an experimental or operational modal analysis come in the form of a collection of modal parameters estimated by the modal estimation algorithm, hereafter called the modal estimator. Various types of modal estimators are known in the art, such as LSCE (Least Squares Complex Exponential), MLE (Maximum Likelihood Estimator) or Poly reference Least Squares Frequency Domain method, better known as PolyMax. The selection of physical modes is usually based on a so-called stabilization diagram. During modal analysis the modal order is generally over-specified to get all the physical modes in the frequency band of interest. This introduces in the stabilization diagram a number of so called spurious or mathematical modes that requires the distinction between physical and non-physical modes. Once the stabilization diagram is built, the task of selecting the physical modes is left to the user, that has to solve two issues: how to distinguish physical modes from computational ones and how to choose the estimate that best represents a certain mode. Moreover the high number of modes identified by the estimator generally includes modes with high damping and high degree of overlapping, making the selection of the valid modes a non-straightforward operation. The manual selection of the modes on the stabilization diagram represents then a significant source of variability, since the set of physical modes selected strongly depends on the ability of the user. Another limitation of the manual procedure of performing modal analysis is related to the increase of the interest in continuously monitoring the vibration level and the evolution of the modal parameters of structures. Repeated manual selection of modes is not an appropriate way of tracking modal parameters over long periods of time.

Automatic mode selection has therefore been investigated. One method is described in document "Fully automated (operational) modal analysis" G. De Roeck E. Reynders J. Houbrechts, Mechanical Systems and Signal Processing 29 (2012), pp. 228-250. In this document, a hierarchical clustering method is used for distinguishing physical modes from mathematical modes. The use of hierarchical clustering is however problematic in that it provides an insufficient degree of certainty that all non-physical modes are detected.

Another aspect that is addressed by the invention is related to signal processing applicable in modal analysis but also in a broader sense, for example in the treatment of electrical signals used in condition monitoring. Data of various kinds are measured or monitored through the analysis of electrical signals obtained from a plurality of sources. In condition monitoring of rotating machines for example, the diagnosis of problems within gears or bearings is often based on the presence and height evolution of certain characteristic frequency peaks in the spectrum of signals obtained from sensors placed on the machines. A small damage of a bearing will result in specific peaks in the frequency spectrum. By monitoring these specific frequency peaks one can monitor the health of the machine. However, the excitation levels related to these peaks are small and therefore often difficult to find, since they are masked by other harmonic content or by noise. For rotating machinery for example, the harmonic content related to the gears is often dominating the spectrum. This makes automatic detection of the peaks related to bearings highly difficult. Peak detection algorithms will tend to detect only the dominant peaks. Therefore it is necessary to filter the dominant harmonics from the signal, such that the remaining peaks are similarly scaled.

One way of mitigating the influence of harmonic peaks is the so-called cepstrum analysis, wherein the Fourier transform of the logarithm of the spectrum is calculated in order to detect families of harmonics in the spectrum. By filtering out detected harmonics and transferring the signal back to the frequency domain and hence to the time domain, the influence of harmonics on the original signal can be mitigated. This technique is however not error-proof, as will be illustrated further in this description.

Another area in which the appearance of harmonics is problematic is the field of operational modal analysis (OMA), already referred to above. OMA aims at identifying the resonance frequencies, damping values and mode shapes of a structure by studying the structure in its normal operational condition. For example, a rotating machine is analysed while the machine is rotating at a given speed. This is different from experimental modal analysis where the system is subjected to a known force excitation (e.g. by a shaker or impact hammer) and the system response is measured.

The main assumption of operational modal analysis is a white noise input. Under this assumption it is possible to estimate the system properties based on output-only measurements. However the assumption is not always correct. For instance in the case of rotating machines there is a significant excitation coming from the rotating components, such as gears. These forces are unknown and they are not white noise. If the assumption of white noise is violated the operational modal analysis techniques become far less efficient. Excitations from coloured noise or harmonic signals will dominate the response signals. Modal estimators will misinterpret the frequency peaks originating from the harmonics as physical resonances. Moreover, if a physical resonance is present at the harmonic frequency it will be masked by the harmonic and undetectable for the modal estimation algorithm.

Methods for the removal of harmonic content in OMA have been studied in the past. As illustrated for example by the document "Continuous-time Operational Modal Analysis in the presence of harmonic disturbances", Pintelon et al., Mechanical Systems and Signal Processing, 22 (2008), 1017-1035, these methods are often based on mathematical models for the harmonic content and of the noise content of the spectrum, wherein parameters of these models are determined in an iterative minimization procedure. This requires a prior knowledge of the system so that a judicious choice of starting values for the mathematical models can be made. Otherwise the method may not converge to a correct solution. Also, these methods require the prior selection of parts of the spectrum on which a specific parameter estimation is performed. Harmonics or other peaks outside these selected windows may then not be removed.

Band pass filtering is another known way of removing harmonic content from the spectrum of a signal. It will however literally produce a gap in the frequency spectrum. If a physical resonance is close to the harmonic excitation frequency, the physical resonance information will also be filtered out. In this case it will be impossible for the modal estimator to identify the physical resonance.

The above-described problems may be generalized to any signal in which frequency components are masking characteristics of the signal that need to be analysed. Improved ways of 'cleaning' a signal are therefore required.

In "Frequency Domain Maximum Likelihood Identification of Sinusoids Applied to Rotating Machinery", Guillaume et al, Proceedings of the 18th International Modal Analysis Conference, pages 411-417, San Antonio, TX, USA, 2000, a parametric frequency-domain Maximum Likelihood approach is proposed to derive accurate estimates of the frequency components (sinusoids) that are present in the vibrations produced by rotating machinery. It is shown that sinusoids can be modelled by means of discrete-time transfer functions.

## Summary of the invention

The invention is related to methods as set out in the appended claims. In a first aspect, methods of the disclosure comprise applying a method for the automatic detection of physical modes from a plurality of mode estimates calculated by a modal estimator for a plurality of modal orders, each mode estimate being defined by an eigenvalue and a mode shape, the method comprising the steps of :

a) Defining a number N of centroid values of N clusters, on the basis of one or more features of the mode estimates,
b) Distributing the mode estimates among the N clusters according to a non-hierarchical clustering algorithm based on said one or more features,
c) Defining a distance function D that expresses a comparison between a mode estimate of a given modal order and the same mode estimate of a lower modal order, and defining a threshold value Dt for said distance function,
d) Calculating the distance between multiple cluster pairs, as the distance function between representative mode estimates of the N clusters,
e) If the distances between the multiple cluster pairs are equal to or above the threshold Dt, concluding that every cluster is associated to one particular mode and going to step g)
f) If the distance between one or more cluster pairs is below the threshold, defining a common centroid for said cluster pairs and repeating step b), d) and e) with an amount of clusters lower than N,
g) Calculating a spuriousness metric for all the mode estimates in the clusters, and deciding at least on the basis of the metric whether a cluster is associated to a physical mode or to a non-physical mode, wherein a mode is selected as physical when the values of the metric of all the mode estimates in a cluster are above a threshold.

According to an embodiment, the spuriousness metric is a silhouette coefficient.

In the above definition of the method according to the first aspect, the silhouette coefficient is defined as (b - a) /max(a,b), with 'a' the mean intra-cluster distance and 'b' the mean nearest-cluster distance for each mode estimate. The distance is calculated in the n-dimensional space defined by the n features on which the clustering algorithm is based.

According to an embodiment, the decision on whether a mode is a physical mode is furthermore taken on the basis of the number of mode estimates in a cluster, and wherein a cluster is associated to a physical mode when the number of mode estimates in the cluster is equal to or higher than a given value.

According to an embodiment, the one or more features of the mode estimates express a comparison between a mode estimate of a given modal order and the same mode estimate of a preceding or subsequent modal order.

According to an embodiment, the features are chosen from the group consisting of :

- Distance between the eigenvalues of the $i^{th}$ mode estimate of the modal order j and of the preceding modal order l :

$$d(\lambda_{i,j}, \lambda_{i,l}) = \frac{\left|\lambda_{i,j} - \lambda_{i,l}\right|}{\max(\left|\lambda_{i,j}\right|, \left|\lambda_{i,l}\right|)}$$

- Distance between the eigenfrequencies of the ith mode estimate of the modal order i and of the preceding modal order l :

$$d(f_{i,j}, f_{i,l}) = \frac{\left|f_{i,j} - f_{i,l}\right|}{\max(\left|f_{i,j}\right|, \left|f_{i,l}\right|)}$$

- Distance between the damping ratios of the ith mode estimate of the modal order j and of the preceding modal order l :

$$d(\xi_{i,j}, \xi_{i,l}) = \frac{\left|\xi_{i,j} - \xi_{i,l}\right|}{\max(\left|\xi_{i,j}\right|, \left|\xi_{i,l}\right|)}$$

- Dimensionless correlation coefficient between the mode shapes of the ith mode estimate of the modal order j and of the preceding modal order l:

$$MAC(\Phi_{i,j}, \Phi_{i,l}) = \frac{\left|\Phi_{i,j}^{H} \Phi_{i,l}\right|}{\left\|\Phi_{i,j}\right\|_2^2 \left\|\Phi_{i,l}\right\|_2^2}$$

According to an embodiment, the distance function is $D_i(j,l) = d(\lambda_{i,j}, \lambda_{i,l}) + 1 - MAC(\Phi_{i,j}, \Phi_{i,l})$ or $D_i(j,l) = d(\lambda_{i,j}, \lambda_{i,l})$ , wherein $d(\lambda_{i,j}, \lambda_{i,l})$ is the distance between the eigenvalues of the ith mode estimate of the modal order j and of the preceding modal order l :

$$d(\lambda_{i,j}, \lambda_{i,l}) = \frac{\left|\lambda_{i,j} - \lambda_{i,l}\right|}{\max(\left|\lambda_{i,j}\right|, \left|\lambda_{i,l}\right|)}$$

and wherein $MAC(\Phi_{i,j}, \Phi_{i,l})$ is a dimensionless correlation coefficient between the mode shapes of the ith mode estimate of the modal order j and of the preceding modal order l:

$$MAC(\Phi_{i,j}, \Phi_{i,l}) = \frac{\left|\Phi_{i,j}^{H} \Phi_{i,l}\right|}{\left\|\Phi_{i,j}\right\|_2^2 \left\|\Phi_{i,l}\right\|_2^2} .$$

According to an embodiment, the threshold Dt of the distance function is equal to $\mu + 2\sigma$, with $\mu$ and $\sigma$ respectively the average and the standard deviation of the distance function calculated for all the mode estimates.
According to an embodiment, the non-hierarchical clustering algorithm is the K-means algorithm.
According to an embodiment, the method is performed multiple times, each time using a different modal estimator, resulting in the detection of physical modes detected automatically through the use of one or more modal estimators.
The invention comprises the application of the above-described method for identifying specific frequency components in a time domain signal. The signal is not necessarily a signal obtained during a modal analysis, but it may be any signal containing specific frequency components, such as a vibration signal obtained from rotating machinery. The latter signal contains harmonics. A modal analysis is performed on the signal, wherein a frequency spectrum of the signal is treated as a frequency response function of a virtual system. The method of the invention allows to identify the frequency components (for example the harmonics) by applying the above method for automatic mode detection to the signal and by identifying the frequency components as 'physical modes' of the virtual system. The distinction between the frequency components and other modes of the virtual system may then be based on specific characteristics of the components. In the case of harmonics, these characteristics may be the damping coefficient and/or the value MAC $(\Phi_{i,j}, \Phi_{i,l})$ of mode estimates in the clusters resulting from the method for automatic mode detection. Alone or in combination with the damping and/or the MAC value, prior knowledge of the system to which the signal is related may be applied such as knowledge of the rotational speed.

According to a second aspect, a method for removing said frequency components from the signal is provided, further comprising :

- synthesizing the one or more selected modes, to thereby obtain one or more synthesized signals in the time domain,
- subtracting the synthesized time domain signals from the original signal, to thereby obtain a cleaned signal with the selected frequency components removed therefrom.

According to an embodiment of the invention, the frequency components are harmonic components of the signal and wherein the selection of the harmonics is done on the basis of the damping coefficient and/or of the value MAC $(\Phi_{i,j}, \Phi_{i,l})$ of mode estimates in the clusters resulting from the method for automatic mode detection, wherein MAC $(\Phi_{i,j}, \Phi_{i,l})$ is a dimensionless correlation coefficient between the mode shapes of the $i^{th}$ mode estimate of the modal order j and of the preceding modal order l :

$$MAC(\Phi_{i,j}, \Phi_{i,l}) = \frac{\left| \Phi_{i,j}{}^{H} \Phi_{i,l} \right|}{\left\| \Phi_{i,j} \right\|_2^2 \left\| \Phi_{i,l} \right\|_2^2}$$

According to an embodiment of the invention, the selection of harmonics may be done on the basis of prior knowledge of characteristics of a system to which the signal is related, such as the rotational speed of a rotating machine or the number of gear teeth on gear wheels of such a machine.

According to an embodiment of the invention, the distance function D applied in the method for automatic mode detection does not depend on MAC $(\Phi_{i,j}, \Phi_{i,l})$, being a dimensionless correlation coefficient between the mode shapes of the $i^{th}$ mode estimate of the modal order j and of the preceding modal order l :

$$MAC(\Phi_{i,j}, \Phi_{i,l}) = \frac{\left| \Phi_{i,j}{}^{H} \Phi_{i,l} \right|}{\left\| \Phi_{i,j} \right\|_2^2 \left\| \Phi_{i,l} \right\|_2^2}$$

According to an embodiment of the invention, the selection of the harmonics occurs automatically.

According to an embodiment of the invention, the signal is an electric signal generated by a sensor mounted on a rotating machine.

According to an embodiment of the invention, the signal is pre-processed before performing the modal analysis and wherein the pre-processing comprises the reduction of harmonic peaks distributed over a plurality of lines in the spectrum of the signal to a single line.

An embodiment of the invention is furthermore related to a method for performing operational modal analysis on a structure, comprising the steps of :

- Obtaining signals in the time domain, from a plurality of locations on the structure,
- Applying the above method according to the invention to the signals, to thereby remove unwanted frequency components from the frequency spectrum of each signal, resulting in a data set of cleaned signals,
- Performing operational modal analysis on the basis of the data set of cleaned signals.

The description is furthermore related to a transducer comprising an embedded signal processor configured to :

- perform a modal analysis on a signal obtained by the transducer, wherein a frequency spectrum of the signal is treated as a frequency response function of a virtual system, thereby identifying a plurality of mode estimates of the virtual system, for multiple modal orders,

- apply the method for automatic detection of physical modes according to the first aspect on the plurality of mode estimates of the virtual system.

According to an embodiment of the transducer, the embedded processor is furthermore configured to :

- select one or more physical modes, corresponding to one or more selected frequency components,
- synthesize the one or more selected modes, to thereby obtain one or more synthesized signals in the time domain,
- subtract the synthesized time domain signals from the original signal, to thereby obtain a cleaned signal with the selected frequency components removed therefrom.

**Brief description of the figures**

Figure 1 shows a stabilization diagram representing modal data obtained by a modal estimation algorithm.
Figures 2a to 2c represent silhouette plots applied in the method of the invention when automatically selecting physical modes.
Figure 3 shows a signal in the time domain, comprising random content as well as harmonic content.
Figure 4 is the frequency spectrum of the signal shown in Figure 1.
Figure 5 shows the original time signal with all synthesized harmonic signals removed.
Figure 6 shows the spectrum with all the harmonic content removed.
Figures 7a to 7c illustrate the superior result obtained by the method of invention compared to the treatment of a signal by cepstrum analysis.
Figures 8a and 8b show two configurations wherein a transducer is applied according to embodiments of the invention.

**Detailed description of the invention**

The first element of the invention is related to a method for automatically detecting physical modes within the data resulting from a modal analysis estimation algorithm (e.g. LSCE, PolyMax or other). The automatic detection is based on a non-hierarchical clustering method wherein the number of clusters is automatically optimized, further making use of a metric for spuriousness within each cluster.

Cluster analysis is the name for a group of multivariate techniques whose primary purpose is to group objects based on the characteristics they possess. The resulting groups (clusters) of objects should then exhibit high internal (within-cluster) homogeneity and high external (between-clusters) heterogeneity. Two different approaches exist : hierarchical clustering and non-hierarchical clustering. Hierarchical clustering algorithms identify the two most similar observations not already in the same cluster and combine them. This rule is applied repeatedly to generate a number of cluster solutions starting with each observation as its own cluster and then combining two clusters at a time until all the observations are in a single cluster. The hierarchical procedure is generally associated to the dendogram (or tree graph), a graphical representation of the results of the hierarchical procedure. Starting with each object as a separate cluster, the dendogram shows graphically how the clusters are combined at each step of the procedure until they all are contained in a single cluster. Depending on the method used to compute the distance between clusters, several algorithms exist. The procedure must be stopped by cutting the hierarchical tree at a certain level, assigning all the objects of each branch at that level to a single cluster. The difficulty encountered in this method is related to the uncertainty involved in deciding when to stop the procedure.

In contrast with hierarchical methods, non-hierarchical clustering algorithms do not involve the tree-like construction process, but they assign objects into clusters once the number of clusters is specified. The methods are generally divided in two steps : first the starting point of each cluster is identified by specifying the cluster seeds, then each observation is assigned to one of the cluster seeds. The most known non-hierarchical clustering method is the K-means algorithm, that aims to partition all the observations into k clusters in which an observation belongs to the cluster with the nearest mean. Another non-hierarchical clustering method is the Fuzzy C-means clustering, with a user-defined number of initial clusters. The K-means algorithm consists of making a choice of the number of clusters and defining the cluster centroids and then looping between two steps. The first step assigns each sample to its nearest centroid. The second step creates new centroids by taking the mean value of all of the samples assigned to each previous centroid. The difference between the old and the new centroids are computed and the algorithm repeats these last two steps until this value is less than a threshold. In other words, it repeats until the centroids do not move significantly. The challenge in any type of non-hierarchical clustering is related to making a correct choice of the number of clusters.

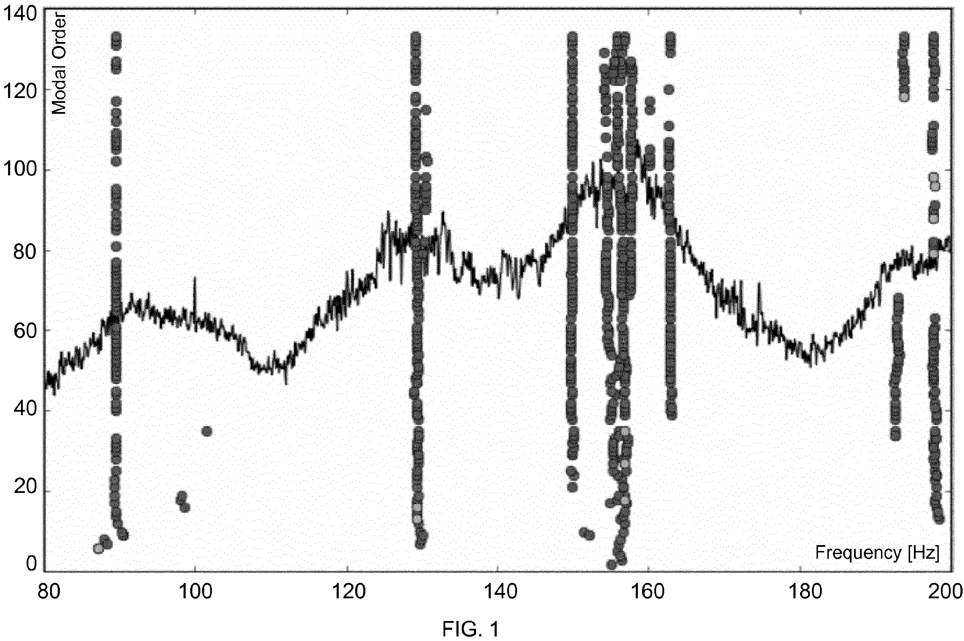

The method of the invention meets this challenge in the specific context of modal analysis data by an automatic iterated sequence that results in a correct number of clusters, allowing a straightforward distinction between physical and non-physical modes. The method starts on the basis of a set of modal data that may be represented by the well-known stabilization diagram, an example of which is illustrated in Figure 1. It is to be noted however that the method of the invention does not require the actual stabilization diagram to be produced. The diagram in Figure 1 is merely used for explaining the method.

Each dot in the stabilization diagram represents a mode estimate calculated by a modal estimator, on the basis of frequency response functions (in experimental MA) or autopower spectra (in operational MA). The estimates are calculated for increasing modal orders, starting with a low modal order at the bottom of the diagram to an increasing modal order for each new horizontal line in the diagram, each horizontal line of dots representing a modal order.

Associated with each mode estimate i are the following modal parameters :

- The complex eigenvalue $\lambda_i = \sigma_i + j\omega_i$ wherein $\omega_i$ equals $2\pi f_i$ with $f_i$ the damped natural frequency of the mode estimate i and wherein $\sigma_i$ is related to the damping ratio $\xi_i$ of the mode estimate i by the formula

$$\xi_i = \frac{-\sigma_i}{\sqrt{\sigma_i^2 + \omega_i^2}}$$

- The mode shape vector $\Phi_i$

The method applies a non-hierarchical clustering algorithm based on a number of features of the available mode estimates. According to a preferred embodiment, a comparison is made between the same mode estimate in two adjacent modal orders. In other words, for each horizontal line j, the $i^{th}$ mode estimate is compared to the $i^{th}$ mode estimate of horizontal line l directly beneath it (in as far as the relevant mode estimates and horizontal lines are available). The following features can then be defined as a basis for the clustering algorithm :

- Distance between the eigenvalues :

$$d(\lambda_{i,j}, \lambda_{i,l}) = \frac{|\lambda_{i,j} - \lambda_{i,l}|}{\max(|\lambda_{i,j}|, |\lambda_{i,l}|)} \quad (1)$$

- Distance between the eigenfrequencies :

$$d(f_{i,j}, f_{i,l}) = \frac{|f_{i,j} - f_{i,l}|}{\max(|f_{i,j}|, |f_{i,l}|)} \quad (2)$$

- Distance between the damping ratios :

$$d(\xi_{i,j}, \xi_{i,l}) = \frac{|\xi_{i,j} - \xi_{i,l}|}{\max(|\xi_{i,j}|, |\xi_{i,l}|)} \quad (3)$$

- Dimensionless correlation coefficient between the mode shapes (MAC):

$$MAC(\Phi_{i,j}, \Phi_{i,l}) = \frac{|\Phi_{i,j}^H \Phi_{i,l}|}{\|\Phi_{i,j}\|_2^2 \|\Phi_{i,l}\|_2^2} \quad (4)$$

The clustering algorithm which may be a known algorithm such as for example the K-mean algorithm, may be based on any one or any group of these features resulting in clusters defined in an n-dimensional space, with n equal to 1, 2, 3 or 4. More than 4 features may be applied and/or other features may be used apart from the four defined above.

However, before a non-hierarchical clustering algorithm can be applied to the pool of available mode estimates (the total number of dots in the stabilization diagram), the number of clusters has to be chosen. Contrary to existing methods, the method of the invention includes an automated procedure for arriving at an optimal number of clusters. For this purpose a distance function $D_i(j,l)$ is defined which compares the $i^{th}$ mode estimate of a modal order j to the same $i^{th}$ mode estimate of the preceding modal order l. According to one embodiment this distance function is defined as :

$$D_i(j,l) = d(\lambda_{i,j},\lambda_{i,l}) + 1 - MAC (\Phi_{i,j},\Phi_{i,l}) \qquad (5)$$

The distance function is calculated for all the available mode estimates (in as far a previous mode estimate is available). The average $\mu$ and standard deviation $\sigma$ of the distance values is calculated. A threshold value Dt may then be defined as the minimum required distance between two clusters.

$$D_t = \mu + 2\sigma \qquad (6)$$

Alternatively, the threshold value Dt may be defined in a different way.

A first clustering step is then performed on the basis of a first choice of the number N of clusters. This can be chosen arbitrarily, but preferably it is equal to the maximum number of mode estimates N of any given modal order, with the initial centroid of each cluster chosen on the basis of the respective mode estimates of the modal order having the maximum number of mode estimates. The clustering algorithm is run for the first time, for example using all four of the features (1) to (4) for distributing the various mode estimates. This results in a number of clusters N. In each of these clusters C a representative mode estimate is chosen. This may for example be done by minimizing the Euclidean distance $d_e$ from the centroid of the cluster in the 2-dimensional space defined by the value of the natural frequency and the damping ratio.

$$d_e = \min_{i \in C} \left( \sqrt{\left| f_i - f_{mean} \right|^2 + \left| d_i - d_{mean} \right|^2} \right) \qquad (7)$$

Then the distance function D is calculated between the representative values of the various clusters resulting from the first clustering step. This is defined as the 'distance between two clusters'. When this distance between two clusters is lower than the threshold value Dt, it is concluded that these two clusters are not related to different modes. The clustering algorithm is repeated with a reduced number of clusters N-1, by defining a common centroid for the pair of clusters that were found to be too close, resulting in these two clusters being merged into a single cluster. These steps are repeated until all the distances between the various clusters are above the threshold value. Possibly in one single iteration, the number of clusters may be diminished by more than one, if more than one pair of clusters are found to be at a mutual distance below the threshold.

A further element of the method of the invention is related to the assessment of the final set of clustered data resulting from the above-described iterative procedure. According to the invention, a metric for spuriousness such as the silhouette coefficient of the mode estimates in each cluster is calculated. Silhouette analysis is known per se, and documented for example on the following internet URL : http://scikit-learn.org/stable/modules/generated/sklearn.metrics.silhouette samples.html#sk learn.metrics.silhouette samples

As stated in the above-cited source, silhouette analysis gives a measure of how similar a mode estimate is to its own cluster compared to other clusters. The silhouette coefficient is calculated using the mean intra-cluster distance (a) and the mean nearest-cluster distance (b) for each mode estimate, the distance being calculated in the n-dimensional space defined by the n features on which the clustering algorithm is based, for example features (1) to (4). The silhouette coefficient for a mode estimate is (b - a) /max(a,b). This function returns the silhouette coefficient for each sample. The silhouette coefficient ranges from -1 to 1, where a high value indicates that the object is well matched to its own cluster and poorly matched to neighbouring clusters.

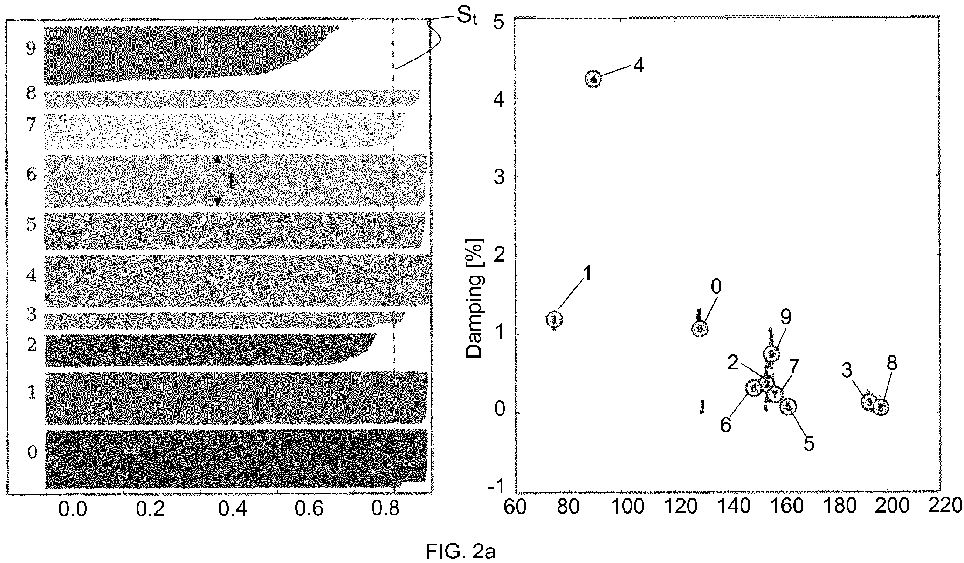

The invention makes advantageous use of the so-called silhouette plot which will be explained on the basis of an example. We refer again to the stabilization diagram of Figure 1. In the first step of the method applied to the mode estimates depicted in this diagram, ten cluster centroids are defined based on ten mode estimates being the maximum number of mode estimates estimated in any modal order estimation (N = 10). The clustering algorithm based on the four features (1) to (4) thus yields ten clusters, labelled 0 to 9. Figure 2a shows the silhouette plot on the left hand side, and further shows the clusters in the 2-dimensional damping/frequency space. The ranking numbers of the ten clusters 0 to 9 have been reproduced in larger lettering in the two-dimensional view to improve readability. The silhouette plot shows for each of the 10 clusters the values of the silhouette coefficients for each mode estimate of the cluster, represented as horizontal lines with a length ranging from 0 to +1 (only positive silhouette coefficients occur in the example). The thicker each silhouette plot (thickness t measured in the vertical direction), the more mode estimates are in the cluster. A threshold value St can furthermore be defined. The more mode estimates have silhouette coefficients above St, the more coherent the cluster is.

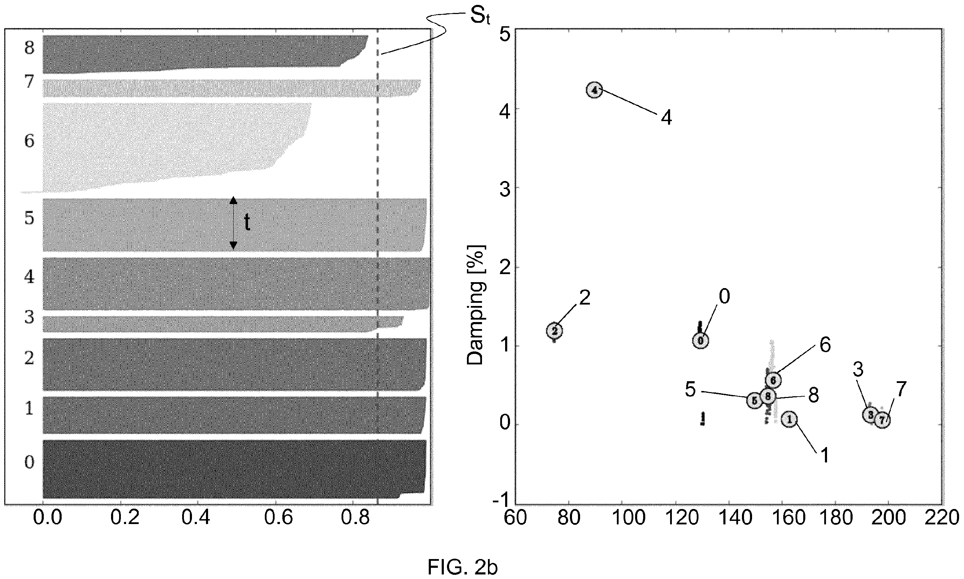

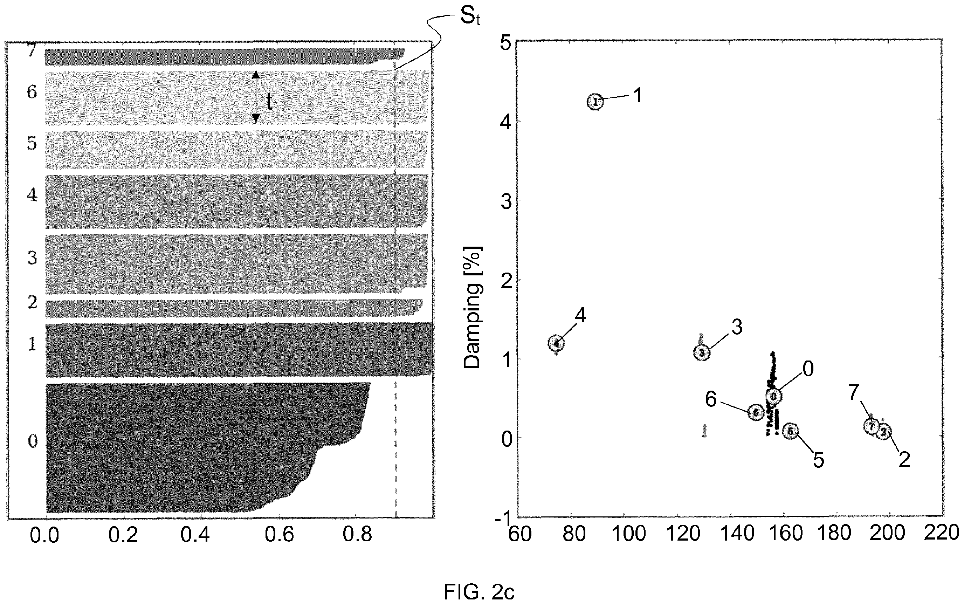

Before assessing the values of the silhouette coefficients however, the above-described automatic procedure for optimizing the number of clusters is performed. The distance as calculated by formula (5) between clusters 7 and 9 is found to be below the threshold value Dt. As a consequence, the number of clusters is reduced to 9 and the clustering algorithm is repeated, resulting in the silhouette plots of Figure 2b. Again the inter-cluster distances are determined, and the clusters 1 and 7 are found to be too close together. A final clustering step with 8 clusters then yields a distribution wherein all the inter-cluster distances D are above the threshold Dt, see Figure 2c.

What follows is then the final assessment of which clusters are associated to physical modes and which are associated to non-physical modes. The method of the invention uses at least the criterion of the silhouette coefficient to judge this. According to an embodiment, a cluster is associated to a physical mode if all the silhouette coefficients of the mode estimates within the cluster are higher than the threshold value St. St may be arbitrarily chosen, e.g. St = 0.85, or it may be chosen as the average value of all the silhouette coefficients calculated for all the mode estimates. According to a further preferred embodiment, an additional criterion is added in the form of a required minimum number of mode estimates in a cluster for the cluster to be regarded as being associated to a physical mode, i.e. a minimum thickness t of the silhouette plot. The minimum number of mode estimates in a cluster may be calculated as :

$$N_{min} = \frac{1}{2} \frac{N_{samples}}{N_{cluster}}$$

where $N_{samples}$ is the total number of mode estimates and $M_{clusters}$ is the number of clusters at the end of the iterations resulting in the number of clusters with intercluster distance higher than Dt.

In the description given above, a number of elements may be applied differently, as indicated by the formulation 'according to an embodiment' or 'may be', etc. For example, the distance function $D_i$ (j,l) may be chosen differently. In cases where the MAC value is less or not relevant, the $D_i(j,l)$ function may for example be defined as $D_i(j,l) = d(\lambda_{i,j}, \lambda_{i,l})$.

The silhouette coefficient is just one example of a metric for spuriousness that can be applied in the method according to the invention. A metric for spuriousness is generally defined as a numeric value that is calculated for each mode in a cluster, and that is relevant to the question of whether or not the modes in said cluster are related to a physical mode or a spurious mode. The latter question may be resolved by assessing the values of the metric in the cluster with respect to a predefined threshold. Instead of the silhouette coefficient, the metric for spuriousness could be the standard deviation of the frequency, the damping or other parameters calculated for the modes in each cluster. Another possible metric is the correlation between the parameters such as frequency or damping of the modes in a cluster, and a constant value for said parameters. The correlation could be calculated in any mathematical manner known in the state of the art. Or a trendline could be fitted to the frequency or damping values of the modes in a cluster. The metric may then be calculated from the deviation between the trendline and a constant value. Other variations of a suitable metric for spuriousness may be imagined by the skilled person without departing from the scope of the present invention.

The basic steps of the method are summarized hereafter: The method starts from a plurality of mode estimates obtained by a modal estimator, for an increasing number of modal orders. The first step of the method consists of choosing a number of clusters N, and distributing the mode estimates among said N clusters by a non-hierarchical clustering algorithm based on one or more features. These features are preferably representative of a comparison between the same mode estimates estimated according to different modal order estimations. An inter-cluster distance function D is then defined and calculated for all the available mode estimates, and a threshold value Dt is defined for the inter-cluster distance D. The intercluster distance is calculated between the N clusters obtained in the first step. If all intercluster distances are above the threshold, the method proceeds to the step of assessing the clusters on the basis of the metric for spuriousness as described above. If one or more intercluster distances are below the threshold, the number of clusters is reduced and the non-hierarchical clustering algorithm is repeated. Again the intercluster distances are calculated and if necessary the clustering algorithm is repeated with a further reduced number of clusters, until all the inter-cluster distances are above the threshold.

According to an embodiment, the method as described above is preceded by a preliminary non-hierarchical clustering step wherein the mode estimates are divided between a cluster consisting of so-called spurious modes and a cluster of possibly physical modes. The spurious modes are the ones which are purely mathematical and therefore have a very low degree of coherence with regard the majority of the other modes. This preliminary separation into spurious and possibly physical modes is also described in the above-referenced document entitled "Fully automated (operational) modal analysis". The method of the invention as described above may then be applied to the cluster of possibly physical mode estimates in order to automatically distinguish within said cluster the mode estimates related to actually physical modes.

The method as described above uses one type of modal estimator, for example LSCE, MLE, PolyMax or any other estimator known in the art, operating in the time domain or in the frequency domain. According to an embodiment, the method is repeated several times, each time using a different modal estimator. It is possible that the method of the invention is able to detect more or less physical modes, depending on the modal estimator that is used. The result is then a list of physical modes detected by one or more different estimators. When the method is applied with a number of different estimators, this results in an increased probability of detecting a maximum of physical modes. Modes detected by multiple estimators can further be assessed and ranked for example based on the number of estimators which have led to the automatic detection of a particular mode.

The automatic detection of physical modes according to the invention, based on one or plurality of modal estimators is directly applicable for the continuous monitoring of modal parameters of a structure.

The invention is related to the use of modal estimators for the identification and removal of specific frequency components such as harmonics from a signal. In a modal analysis context and in various other technical areas involving signal processing, a signal is obtained in the time domain, for example an acceleration signal coming from a condition monitoring sensor or from an accelerometer applied in a modal analysis test setup. According to the second element of this invention, this signal is used as the input of a modal estimator. What is applied in the second element of the invention is the fact that a modal analysis algorithm can in fact be applied directly to any signal that has a given frequency content, i.e. peaks occurring in the frequency spectrum of the signal obtained by a Fourier transform of the time domain signal. Normally when a modal analysis (conventional or operational) is performed on a structure, the MA algorithm is based on a set of frequency response functions (FRFs), which link a response (an acceleration signal obtained at a location of the structure) to an input. In conventional MA, the input is the measured input force (e.g. shaker force) while the various signals are obtained from transducers mounted on the structure or other sensing means. In operational modal analysis, the input force is not known. Therefore auto-power and cross-power spectra between response signals and one or more chosen reference signals are traditionally used in OMA to generate these functions. These auto- and cross-power spectra are used as frequency response functions which serve as input for the operational modal analysis algorithm.

The methods according to the second element of the invention treat a frequency spectrum of one signal (possibly after pre-processing, see further) as if it was a frequency response function of a given system and proceeds to find the modes of the system, i.e. the poles (natural frequencies and damping values) and mode shapes. The determination of these modes may be done by any known modal analysis algorithm, operating either in the frequency domain or in the time domain, and without requiring any knowledge of the 'system' characterised by the 'frequency response function'. Such a system is referred to as a 'virtual' system in the present context. The modal analysis algorithm proceeds to calculate mode estimates for an increasing modal order, in the manner described in relation to the first element of the invention. As in an actual modal analysis, the modal estimator thus yields a plurality of mode estimates, hereafter referred to as 'signal mode estimates'.

According to a preferred embodiment, the modal estimator algorithm that is used for determining the signal mode estimates is a discrete time domain estimator, which allows the estimation of the signal mode estimates even when leakage between frequency lines is occurring.

When the frequency spectrum of a signal comprises harmonics, for example in a signal originating from rotating machinery, these harmonic peaks are identified as signal modes by the modal estimator. These signal modes are however not related to structural resonance modes, but they are generated purely by the presence of the harmonics in the spectrum. According to the second element of the invention, the harmonics or other specific peaks are automatically detected by applying the clustering method according to the first element of the invention for the automatic selection of physical modes. The harmonics may then be removed from the signal. The methods are explained hereafter for the identification and removal of harmonics, but is applicable to the identification and removal of similar peaks from a spectrum. The clustering method is applied to the plurality of signal mode estimates resulting from the modal estimation algorithm being applied to the signal. The automatic detection method is tuned to detect the harmonics as physical modes of the virtual system. In other words, the clustering method results in a number of clusters of mode estimates. Some of these clusters are associated to the harmonics which are interpreted by the clustering method as 'physical' modes. The final distinction between the harmonics and actual physical modes appearing in the signal is made on the basis of the modal parameters of the harmonic 'modes', such as the damping coefficient of the mode estimates in the harmonic clusters and/or the MAC value between harmonic mode estimates of adjacent modal orders, as calculated by formula (4). The damping is expected to be very low for harmonic modes and the MAC value is also expected to be low. Harmonic modes can thus be detected by setting a low threshold value on the damping and/or the MAC value.

Another criterium for the detection of harmonics, to be used in combination with the damping and/or the MAC value, is any prior knowledge regarding the system to which the time signal is related. For example on a rotating machine, the rotational speed may be known, or the number of teeth on gear wheels of the machine. This knowledge may be used in the automatic detection of harmonics among the 'physical modes' : harmonics are selected based on whether or not they correspond to 1st or higher order spectral components of the rotational speed or of gear meshing frequencies.

In order to detect the harmonic modes as 'physical' modes, the distance function $D_i(j,l)$ cannot depend on the MAC value between adjacent modal orders, as this MAC value will not be coherent for adjacent harmonic modes. So in this case the distance function may for example be chosen as $D_i(j,l) = d(\lambda_{i,j}, \lambda_{i,l})$. This function will be coherent because harmonic modes will be estimated consistently at the same frequency and (low) damping. Besides this, the method according to the first element of the invention may be applied as described above, yielding a number of clusters which can be automatically divided in non-physical and physical. The harmonic modes are part of the 'physical' clusters. The further automatic distinction between harmonic modes and actual physical modes is then made on the basis of the damping and/or the MAC value as described above.

The method for removal of frequency components according to the second element of the invention then proceeds to the synthesis of frequency spectra and/or time signals on the basis of one or more of the harmonic modes. This means that one or more signals are reconstructed based on each of the selected harmonic modes and the modal parameters associated thereto. The synthesis can take place in the frequency domain or in the time domain. In the first case, a synthesized frequency spectrum is generated for every one of the selected modes. These spectra are subsequently converted to the time domain by an inverse Fourier transform. In the second case, time domain signals are directly synthesized from the modal parameters of the selected modes.

In the final step of the method, the synthesized time signals are subtracted from the original time signal, resulting in a signal that is free from the selected content, i.e. free form the harmonics.

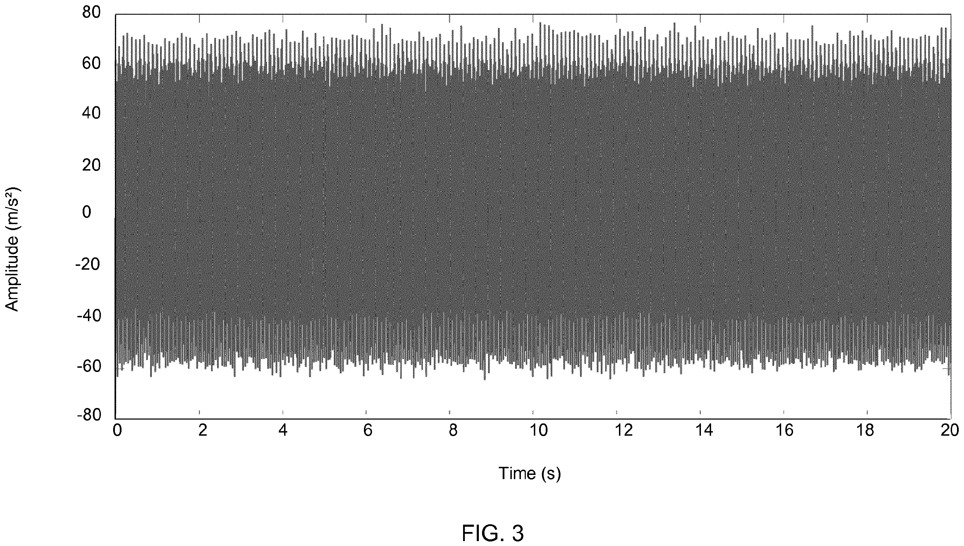

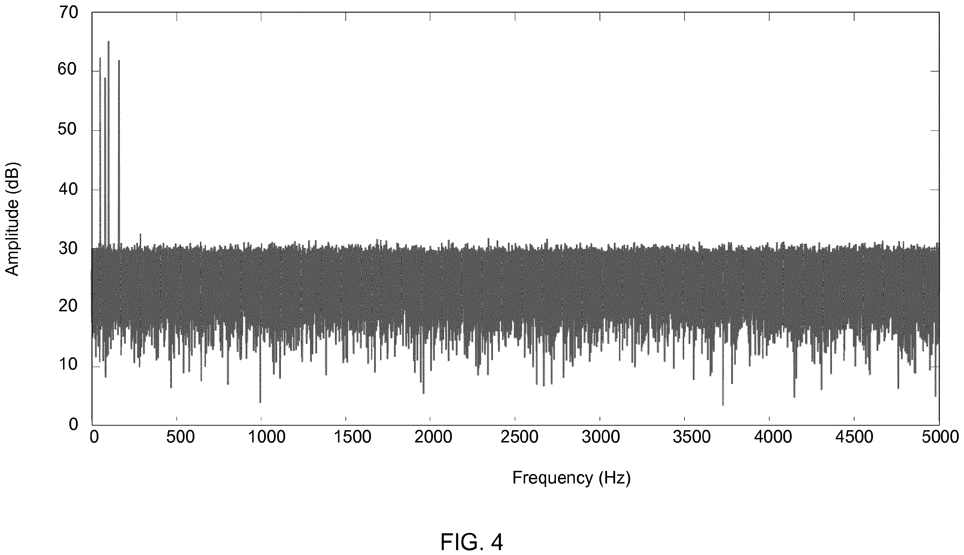

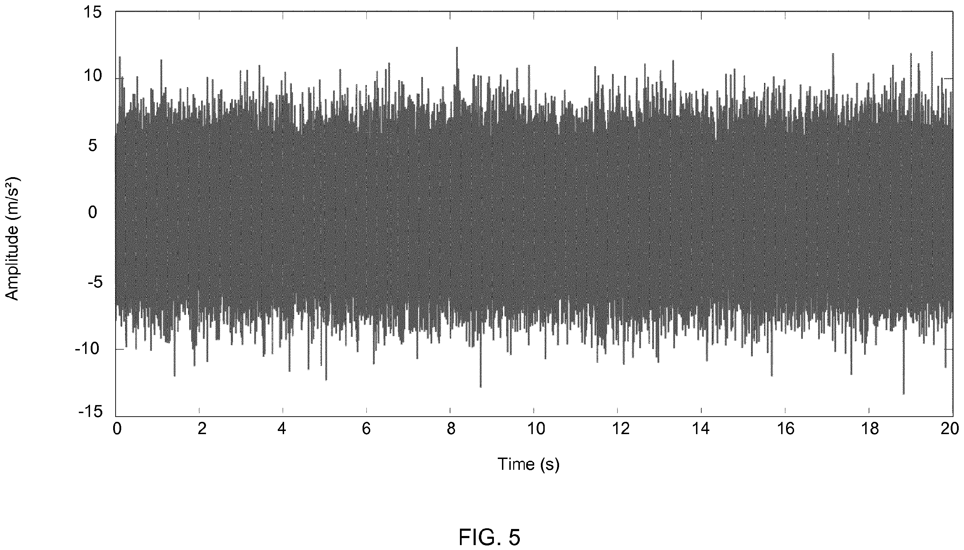

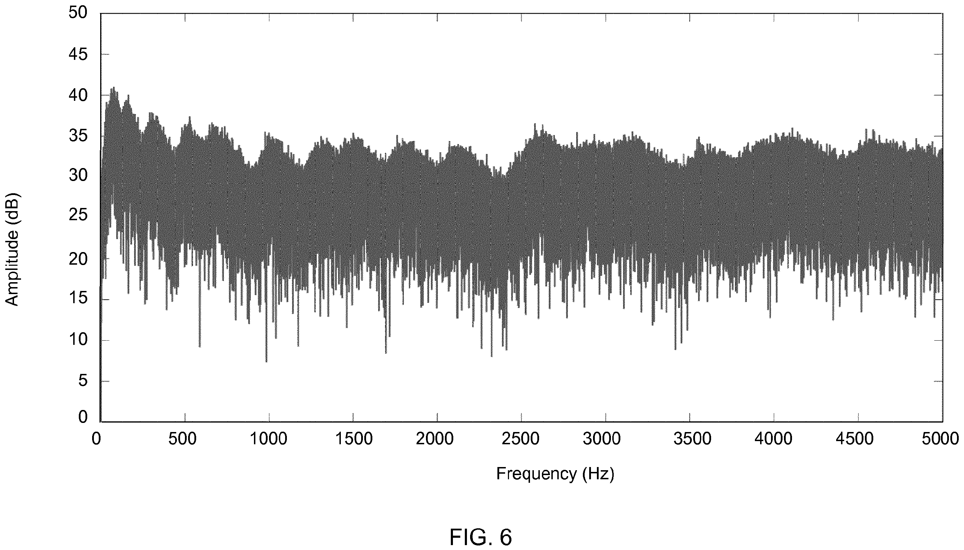

Any known modal estimator can be used in the methods according to the second element of the invention. The following example illustrates the method applied to a simulated vibration signal, and with the use of a modal estimator operating in the frequency domain. Figure 3 shows the time signal. Figure 4 shows the frequency spectrum obtained by a Fourier transform of the signal of Figure 3. A number of peaks are visible which are due to harmonics, at 50Hz, 80Hz, 100Hz and 160Hz. The spectrum of Figure 4 is used as input to a modal estimator. In this case, the polyMAX modal estimator was used, which is a known modal estimator. The harmonics at 50Hz, 80Hz, 100Hz and 160Hz are automatically detected as harmonic modes by the above-described method, using the method according to the first element of the invention for detecting the physical and harmonic modes. The harmonic modes are synthesized in the frequency domain. The synthesized spectra are converted back to the time domain by an inverse Fourier transform, and subtracted from the original time signal. The time signal with all selected harmonics subtracted in this way is shown in Figure 5. The Fourier transform yields the spectrum shown in Figure 6. It is seen that the harmonics have effectively been removed, i.e. the signal has been cleaned from harmonic content. The actual removal of harmonics in the above-described way is done automatically. Sometimes it may be useful to maintain sidebands or higher order harmonics, for example in condition monitoring signals. It is advantageous in that case not to remove these sidebands from the signal, which requires a manual selection.

The methods according to the second element of the invention can be used in various domains, not only in machine monitoring but on any signal from which specific frequency components need to be removed. In other words, the signal may represent a vibration of a structural component, but it can also represent a supply voltage of an electrical device, an output signal of a temperature sensor, or any other signal representing a physical parameter.

One major application of the method for removing components according to the second element of the invention is in the performance of operational modal analysis, as a novel way of removing unwanted content from a data set that may consist of acceleration signals obtained from various locations on a structure. The main application is the removal of harmonic content from signals obtained on a rotating machine under investigation by OMA. The method of the invention is applied directly to each of these signals, i.e. not on auto-power and cross-power spectra of the signals to a given reference. Application of the method to each signal allows to remove the harmonic content from each signal, and hence to clean the signals by subtraction of the synthesized harmonic peaks, as described above. The cleaned signals are then used as input for the actual OMA analysis on the structure, i.e. by studying auto- and cross-power spectra of the cleaned signals to a cleaned reference and calculation of the modal parameters of the structure. The signals which are cleaned by the method of the invention have the advantage that the white noise assumption is effectively fulfilled, thereby increasing the quality of the modal parameter estimation.

Compared to existing methods of harmonic removal in OMA, the method of the invention regards the spectra of the acceleration signals as 'frequency response functions' of a virtual 'system'. This system is different for each signal and has no relation to the actual structure under investigation. This means that no prior knowledge of a dynamic model of the structure under investigation is required nor a prior selection of a given frequency range, nor a mathematical model of the harmonic content. The method furthermore allows to remove harmonic content but also other peaks which may be detrimental to the signal quality. In each signal, the presence of harmonics as well as such other peaks is detected by the method according to the first element of the invention. In this way, the removal of all harmonic content as well as other content that is detrimental to the signal quality can be assured. This is not possible with the prior methods for harmonic removal in OMA.

Compared to methods which apply a band pass filtering approach, the method of the invention is advantageous as it allows to remove unwanted frequency components without removing the frequency content in the filtered frequency band.

According to embodiments of the second element of the invention, the signals are pre-processed prior to the application of the methods of the second element of the invention. This may for example be the case for signals obtained on a rotating machine of which the rotational speed is fluctuating as a function of time. As a consequence, the harmonic peaks are distributed over a number of lines in the spectrum. A pre-processing step may be performed on the signal in order to reduce the plurality of lines in the spectrum to a single peak. Such pre-processing is known in the art and may for example involve the use of a tacho signal together with the obtained signal, or by an off-line estimation of speed fluctuations based on the signal itself. It is to be noted however that even without such pre-processing, the method of the invention allows to clean the signal. It was found by the inventors that the method is capable of identifying the plurality of lines as separate modes of the virtual system, so that each of these lines may be cleaned separately from the spectrum. This proves that the method is a powerful and flexible tool.

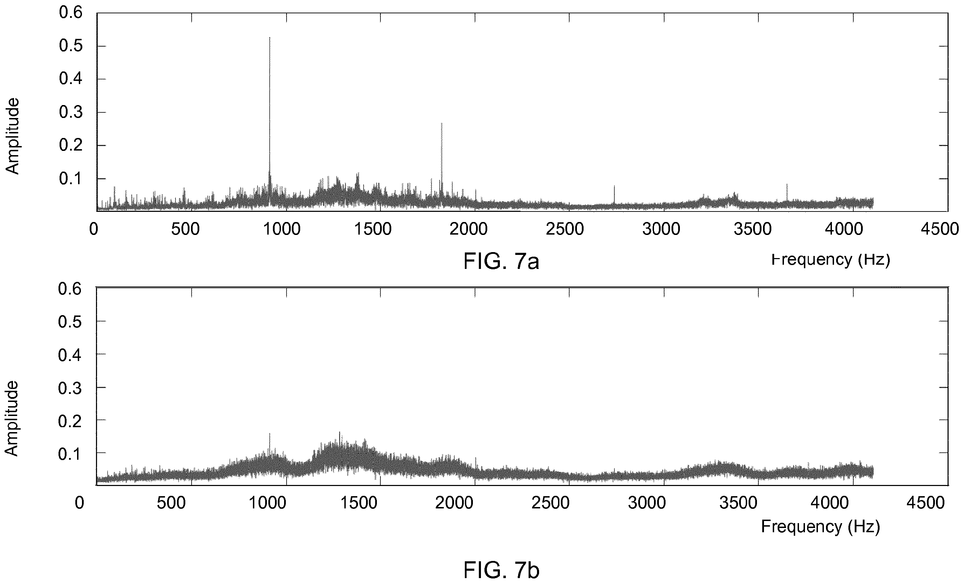

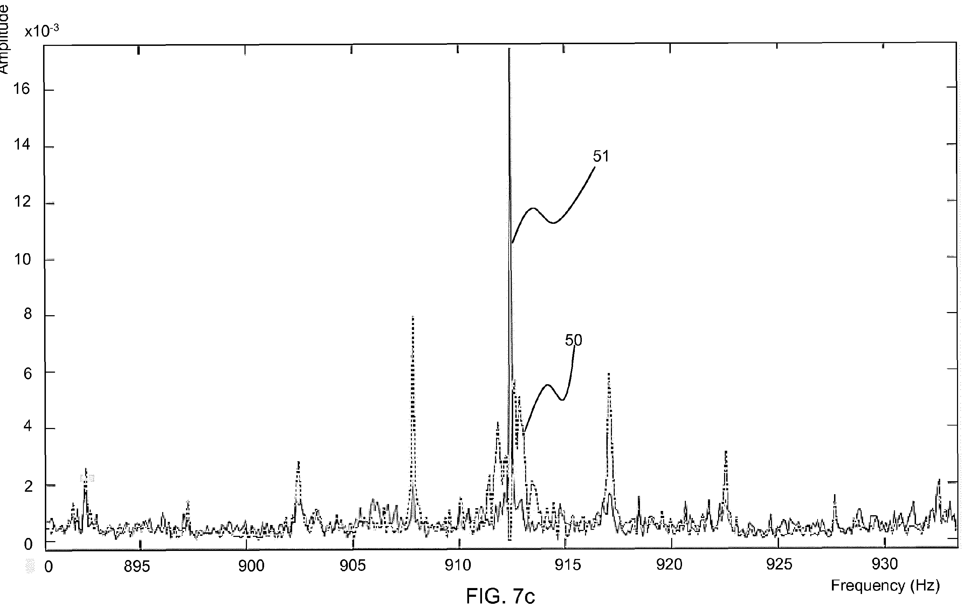

As a further illustration of the advantages of the invention over existing methods, Figure 7 compares a spectrum of a cleaned signal obtained by the method according to the second element of the invention to a signal treated by cepstrum analysis. Figure 7a shows the original spectrum, Figure 7b the cepstrum-treated spectrum. The cepstrum method is not able to remove the harmonic peaks completely and furthermore makes a change to the overall frequency content. The method of the invention provides a signal with harmonics removed and the frequency content intact. As shown in the detail in Figure 7c, the method of the invention (curve 50) leaves the sidebands of the harmonic at 920Hz intact, whereas these sidebands are removed by the cepstrum technique (curve 51). These sidebands are related to gear failure and therefore important in condition monitoring applications. The method of the invention allows to leave the sidebands intact by deliberately not subtracting the synthesized modes associated with these sidebands from the original signal.

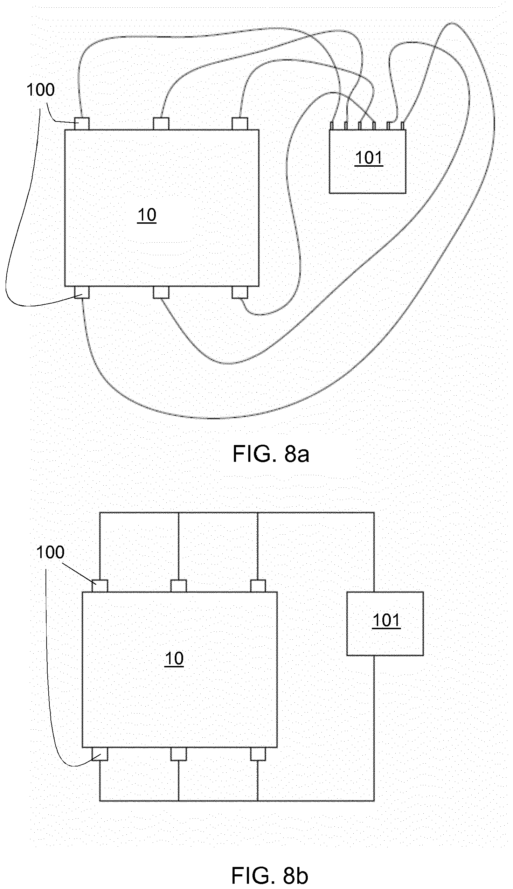

The invention is furthermore related to a transducer comprising an embedded signal processor programmed to automatically perform the method according to the the invention on a signal measured by the transducer. The transducer may be configured to measure any type of signal or multiple signals known in the art for machine monitoring or modal analysis, or for other purposes. Figures 8a and 8b illustrate two possible ways of applying a transducer according to the invention. In the setup of Figure 8a, transducers 100 mounted on a structure 10 are coupled to a processing unit 101 via separate cables. In the setup of Figure 8b, the transducers 100 are connected to a processing unit 101 in a network configuration. The processing unit 101 may be a processing unit for performing modal analysis for example. According to a first embodiment of the transducer, the method according to the first element is applied to a signal in the transducer itself, i.e. the automatic detection of 'physical modes' of the virtual system corresponding to the signal is done by the embedded processor, yielding a set of 'physical' modes, some of which correspond to harmonic peaks for example. Preferably an automatic detection of harmonics or other specific peaks among said physical peaks is equally done by the embedded processor. The selection of harmonics and the removal of said harmonics is then performed by the processing unit 101. According to a second embodiment, the removal of harmonics is equally done automatically by the embedded processor, before transferring the signals to the processing unit 101. In the latter case, the processing unit 101 receives signals that are cleaned from harmonic and/or other unwanted content.

**Claims**

1. A method for identifying specific frequency components in a signal, the method comprising :

    obtaining the signal in the time domain,
    performing modal analysis on the signal by inputting the signal to a modal estimator, wherein a frequency spectrum of the signal is treated as a frequency response function of a virtual system, thereby identifying a plurality of mode estimates of the virtual system, for a plurality of modal orders,
    applying a method for the automatic detection of physical modes from the plurality of mode estimates for the plurality of modal orders, each mode estimate being defined by an eigenvalue and a mode shape, comprising the steps of :

        a) defining a number N of centroid values of N clusters, on the basis of one or more features of the mode estimates,
        b) distributing the mode estimates among the N clusters according to a non-hierarchical clustering algorithm based on said one or more features,
        c) defining a distance function D that expresses a comparison between a mode estimate of a given modal order and the same mode estimate of a lower modal order, and defining a threshold value Dt for said distance function,
        d) calculating the distance between multiple cluster pairs, as the distance function between representative mode estimates of the N clusters,

e) if the distances between the multiple cluster pairs are equal to or above the threshold Dt, concluding that every cluster is associated to one particular mode and going to step g)

f) if the distance between one or more cluster pairs is below the threshold, defining a common centroid for said cluster pairs and repeating step b), d) and e) with an amount of clusters lower than N,

g) calculating a metric for spuriousness for all the mode estimates in the clusters, and deciding at least on the basis of the metric whether a cluster is associated to a physical mode or to a non-physical mode, wherein a mode is selected as physical when the values of the metric of all the mode estimates in a cluster are above a threshold, and

selecting one or more physical modes, corresponding to said frequency components.

2. A method for the removal of frequency components from a signal, the method comprising the steps of:

applying the method for identifying specific frequency components in a signal according to claim 1 to said signal to obtain one or more physical modes; and
automatically removing frequency components from the signal, comprising:

synthesizing the one or more selected physical modes, to thereby obtain one or more synthesized signals in the time domain,
subtracting the synthesized time domain signals from the original signal, to thereby obtain a cleaned signal with the selected frequency components removed therefrom.

3. A method for performing operational modal analysis on a structure, comprising the steps of :

• Obtaining signals in the time domain, from a plurality of locations on the structure,
• Applying the method according to claim 2 to the signals, to thereby remove unwanted frequency components from the frequency spectrum of each signal, resulting in a data set of cleaned signals,
• Performing operational modal analysis on the basis of the data set of cleaned signals.

4. The method according to any one of the preceding claims, wherein the decision on whether a mode is a physical mode is furthermore taken on the basis of the number of mode estimates in a cluster, and wherein a cluster is associated to a physical mode when the number of mode estimates in the cluster is equal to or higher than a given value.

5. The method according to any one of the preceding claims, wherein the one or more features of the mode estimates express a comparison between a mode estimate of a given modal order and the same mode estimate of a preceding or subsequent modal order.

6. The method according to claim 5, wherein the features are chosen from the group consisting of :

• distance between the eigenvalues of the $i^{th}$ mode estimate of the modal order j and of the preceding modal order l :

$$d(\lambda_{i,j}, \lambda_{i,l}) = \frac{\left|\lambda_{i,j} - \lambda_{i,l}\right|}{\max(\left|\lambda_{i,j}\right|, \left|\lambda_{i,l}\right|)}$$

• distance between the eigenfrequencies of the $i^{th}$ mode estimate of the modal order j and of the preceding modal order l :

$$d(f_{i,j}, f_{i,l}) = \frac{\left|f_{i,j} - f_{i,l}\right|}{\max(\left|f_{i,j}\right|, \left|f_{i,l}\right|)}$$

• distance between the damping ratios of the $i^{th}$ mode estimate of the modal order j and of the preceding modal

order l :

$$d(\xi_{i,j}, \xi_{i,l}) = \frac{\left|\xi_{i,j} - \xi_{i,l}\right|}{\max(\left|\xi_{i,j}\right|, \left|\xi_{i,l}\right|)}$$

• dimensionless correlation coefficient between the mode shapes of the i$^{th}$ mode estimate of the modal order j and of the preceding modal order l:

$$MAC(\Phi_{i,j}, \Phi_{i,l}) = \frac{\left|\Phi_{i,j}^{\ H} \Phi_{i,l}\right|}{\left\|\Phi_{i,j}\right\|_2^2 \left\|\Phi_{i,l}\right\|_2^2}$$

7. The method according to any one of the preceding claims wherein the distance function is $D_i(j,l) = d(\lambda_{i,j}, \lambda_{i,l}) + 1 - MAC(\Phi_{i,j}, \Phi_{i,l})$ or $D_i(j,l) = d(\lambda_{i,j}, \lambda_{i,l})$ , wherein $d(\lambda_{i,j}, \lambda_{i,l})$ is the distance between the eigenvalues of the i$^{th}$ mode estimate of the modal order j and of the preceding modal order l :

$$d(\lambda_{i,j}, \lambda_{i,l}) = \frac{\left|\lambda_{i,j} - \lambda_{i,l}\right|}{\max(\left|\lambda_{i,j}\right|, \left|\lambda_{i,l}\right|)}$$

and wherein MAC ($\Phi_{i,j}, \Phi_{i,l}$) is a dimensionless correlation coefficient between the mode shapes of the i$^{th}$ mode estimate of the modal order j and of the preceding modal order l:

$$MAC(\Phi_{i,j}, \Phi_{i,l}) = \frac{\left|\Phi_{i,j}^{\ H} \Phi_{i,l}\right|}{\left\|\Phi_{i,j}\right\|_2^2 \left\|\Phi_{i,l}\right\|_2^2} .$$

8. The method according to any one of the preceding claims, wherein the threshold Dt of the distance function is equal to $\mu + 2\sigma$, with $\mu$ and $\sigma$ respectively the average and the standard deviation of the distance function calculated for all the mode estimates.

9. The method according to any one of the preceding claims, wherein the method is performed multiple times, each time using a different modal estimator, resulting in the detection of physical modes detected automatically through the use of one or more modal estimators.

10. The method according to any one of the preceding claims, wherein the metric for spuriousness is the silhouette coefficient.

11. The method according to any one of the preceding claims, wherein the frequency components are harmonic components of the signal and wherein the selection of the harmonics is done on the basis of the damping coefficient and/or of the value MAC ($\Phi_{i,j}, \Phi_{i,l}$) of mode estimates in the clusters resulting from the method for automatic mode detection, wherein MAC ($\Phi_{i,j}, \Phi_{i,l}$) is a dimensionless correlation coefficient between the mode shapes of the i$^{th}$ mode estimate of the modal order j and of the preceding modal order l :

$$MAC(\Phi_{i,j}, \Phi_{i,l}) = \frac{\left|\Phi_{i,j}^{\ H} \Phi_{i,l}\right|}{\left\|\Phi_{i,j}\right\|_2^2 \left\|\Phi_{i,l}\right\|_2^2}$$

12. The method according to any one of the preceding claims, wherein the distance function D applied in the method for automatic mode detection does not depend on MAC ($\Phi_{i,j},\Phi_{i,l}$), being a dimensionless correlation coefficient between the mode shapes of the $i^{th}$ mode estimate of the modal order j and of the preceding modal order l :

$$MAC(\Phi_{i,j},\Phi_{i,l}) = \frac{\left|\Phi_{i,j}^{H}\Phi_{i,l}\right|}{\left\|\Phi_{i,j}\right\|_2^2\left\|\Phi_{i,l}\right\|_2^2}$$

13. The method according to any one of the preceding claims, wherein the signal is an electric signal generated by a sensor mounted on a rotating machine.

14. The method according to any one of the preceding claims, wherein the signal is pre-processed before performing the modal analysis and wherein the pre-processing comprises the reduction of harmonic peaks distributed over a plurality of lines in the spectrum of the signal to a single line.

15. The method according to claim 2, wherein the method is applied on a signal obtained by a transducer (100) and performed by a signal processor embedded in the transducer (100).

**Patentansprüche**

1. Ein Verfahren zum Identifizieren spezifischer Frequenzkomponenten in einem Signal, das Verfahren umfassend:

Erlangen des Signals in dem Zeitbereich,
Ausführen von Modalanalyse an dem Signal durch Eingeben des Signals in einen Modalschätzer, wobei ein Frequenzspektrum des Signals als eine Frequenzantwortfunktion eines virtuellen Systems behandelt wird, wodurch eine Vielzahl von Modeschätzungen des virtuellen Systems für eine Vielzahl von Modalordnungen identifiziert wird,
Anwenden eines Verfahrens zur automatischen Erkennung von physischen Modi aus der Vielzahl von Modeschätzungen für die Vielzahl von modalordnungen, wobei jede Modeschätzung durch einen Eigenwert und eine Modeform definiert ist, umfassend die folgenden Schritte:

a) Definieren einer Anzahl N von Schwerpunktwerten von N-Clustern basierend auf einem oder mehreren Merkmalen der Modeschätzungen,
b) Verteilen der Modeschätzungen unter den N-Clustern gemäß einem nichthierarchischen Clustering-Algorithmus basierend auf dem oder den besagten einen oder mehreren Merkmalen,
c) Definieren einer Abstandsfunktion D, die einen Vergleich zwischen einer Modeschätzung einer gegebenen modalordnung und derselben Modeschätzung einer niedrigeren modalordnung ausdrückt, und Definieren eines Schwellenwerts Dt für die Abstandsfunktion,
d) Berechnen des Abstands zwischen mehreren Clusterpaaren als die Abstandsfunktion zwischen repräsentativen Modeschätzungen der N_Cluster,
e) wenn die Abstände zwischen den mehreren Clusterpaaren gleich wie oder größer als der Schwellenwert Dt sind, Schlussfolgern, dass jeder Cluster mit einem jeweiligen Mode assoziiert ist, und Gehen zu Schritt g),
f) wenn der Abstand zwischen einem oder mehreren Clusterpaaren unter dem Schwellenwert ist, Definieren eines gemeinsamen Schwerpunkts für die besagten Clusterpaare und Wiederholen von Schritt b), d) und e) mit einer Anzahl von Clustern kleiner als N,
g) Berechnen einer Metrik für Scheinrichtigkeit für alle Modeschätzungen in den Clustern und Entscheiden zumindest basierend auf der Metrik, ob ein Cluster mit einem physischen Mode oder einem nicht-physischen Mode assoziiert ist,

wobei ein Modus als physisch ausgewählt wird, wenn die Werte der Metrik aller Modeschätzungen in einem Cluster über einem Schwellenwert sind, und
Auswählen einer oder mehrerer physischer Moden, die den besagten Frequenzkomponenten entsprechen.

2. Ein Verfahren zur Entfernung von Frequenzkomponenten aus einem Signal, das Verfahren umfassend die folgenden Schritte:

Anwenden des Verfahrens zum Identifizieren spezifischer Frequenzkomponenten in einem Signal gemäß Anspruch 1 auf das besagte Signal, um eine oder mehrere physische Moden zu erlangen; und automatisches Entfernen von Frequenzkomponenten aus dem Signal, umfassend:

Synthetisieren des einen oder der mehreren ausgewählten physischen Moden, um dadurch ein oder mehrere synthetisierte Signale in dem Zeitbereich zu erlangen, Subtrahieren der synthetisierten Zeitbereichssignale von dem ursprünglichen Signal, um dadurch ein bereinigtes Signal, aus dem die ausgewählten Frequenzkomponenten entfernt wurden, zu erlangen.

3. Ein Verfahren zum Ausführen einer Betriebsmodalanalyse an einer Struktur, umfassend die folgenden Schritte:

• Erlangen von Signalen in dem Zeitbereich, von einer Vielzahl von Stellen an der Struktur,
• Anwenden des Verfahrens nach Anspruch 2 auf die Signale, um dadurch unerwünschte Frequenzkomponenten aus dem Frequenzspektrum von jedem Signal zu entfernen, was in einem Datensatz von bereinigten Signalen resultiert,
• Ausführen von Betriebsmodalanalyse basierend auf dem Datensatz von bereinigten Signalen.

4. Das Verfahren nach irgendeinem der vorherigen Ansprüche, wobei die Entscheidung, ob ein Mode ein physischer Mode ist, ferner basierend auf der Anzahl der Modeschätzungen in einem Cluster getroffen wird, und wobei ein Cluster mit einem physischen Mode assoziiert wird, wenn die Anzahl der Modeschätzungen in dem Cluster gleich wie oder größer als ein gegebener Wert ist.

5. Das Verfahren nach irgendeinem der vorherigen Ansprüche, wobei das eine oder die mehreren Merkmale der Modeschätzungen einen Vergleich zwischen einer Modeschätzung einer gegebenen modalordnung und der gleichen Modeschätzung einer vorherigen oder nachfolgenden modalordnung ausdrücken.

6. Das Verfahren nach Anspruch 5, wobei die Merkmale ausgewählt sind aus der Gruppe bestehend aus:

• Abstand zwischen den Eigenwerten der i-ten Modeschätzung der modalordnung j und der vorherigen modalordnung l:

$$d(\lambda_{i,j}, \lambda_{i,l}) = \frac{\left|\lambda_{i,j} - \lambda_{i,l}\right|}{\max(\left|\lambda_{i,j}\right|, \left|\lambda_{i,l}\right|)}$$

• Abstand zwischen den Eigenfrequenzen der i-ten Modeschätzung der modalordnung j und der vorherigen modalordnung l:

$$d(f_{i,j}, f_{i,l}) = \frac{\left|f_{i,j} - f_{i,l}\right|}{\max(\left|f_{i,j}\right|, \left|f_{i,l}\right|)}$$

• Abstand zwischen den Dämpfungsverhältnissen der i-ten Modeschätzung der modalordnung j und der vorherigen modalordnung l:

$$d(\xi_{i,j}, \xi_{i,l}) = \frac{\left|\xi_{i,j} - \xi_{i,l}\right|}{\max(\left|\xi_{i,j}\right|, \left|\xi_{i,l}\right|)}$$

• dimensionsloser Korrelationskoeffizient zwischen den Modalformen der i-ten Modeschätzung der modalordnung j und der vorherigen modalordnung l:

$$MAC(\Phi_{i,j},\Phi_{i,l}) = \frac{\left|\Phi_{i,j}^{H}\Phi_{i,l}\right|}{\left\|\Phi_{i,j}\right\|_{2}^{2}\left\|\Phi_{i,l}\right\|_{2}^{2}}.$$

7. Das Verfahren nach irgendeinem der vorherigen Ansprüche, wobei die Abstandsfunktion $D_i(j,l) = d(\lambda_{i,j}, \lambda_i,l) + 1 - MAC(\Phi_{i,j}, \Phi_{i,l})$ oder $D_i(j,l) = d(\lambda_{i,j}, \lambda_{i,l})$ ist, wobei $d(\lambda_{i,j}, \lambda_{i,l})$ der Abstand zwischen den Eigenwerten der i-ten Modeschätzung der modalordnung j und der vorherigen modalordnung l ist:

$$d(\lambda_{i,j},\lambda_{i,l}) = \frac{\left|\lambda_{i,j} - \lambda_{i,l}\right|}{\max(\left|\lambda_{i,j}\right|,\left|\lambda_{i,l}\right|)}$$

und wobei MAC $(\Phi_{i,j}, \Phi_{i,l})$ ein dimensionsloser Korrelationskoeffizient zwischen den Modalformen der i-ten Modeschätzung der modalordnung j und der vorherigen modalordnung l ist:

$$MAC(\Phi_{i,j},\Phi_{i,l}) = \frac{\left|\Phi_{i,j}^{H}\Phi_{i,l}\right|}{\left\|\Phi_{i,j}\right\|_{2}^{2}\left\|\Phi_{i,l}\right\|_{2}^{2}}.$$

8. Das Verfahren nach irgendeinem der vorherigen Ansprüche, wobei der Schwellenwert Dt der Abstandsfunktion gleich $\mu + 2\sigma$ ist, wobei $\mu$ und $\sigma$ der Mittelwert bzw. die Standardabweichung der Abstandsfunktion, die für alle Modeschätzungen berechnet wird, ist.

9. Das Verfahren nach irgendeinem der vorherigen Ansprüche, wobei das Verfahren mehrfach ausgeführt wird, wobei jedes Mal ein anderer Modalschätzer verwendet wird, was in der Erkennung physischer Modi, die automatisch durch die Verwendung eines oder mehrerer Modalschätzer erkannt werden, resultiert.

10. Das Verfahren nach irgendeinem der vorherigen Ansprüche, wobei die Metrik für Scheinrichtigkeit der Silhouettenkoeffizient ist.

11. Das Verfahren nach irgendeinem der vorherigen Ansprüche, wobei die Frequenzkomponenten harmonische Komponenten des Signals sind und wobei die Auswahl der Harmonischen basierend auf dem Dämpfungskoeffizienten und/oder dem Wert MAC $(\Phi_{i,j}, \Phi_{i,l})$ von Modeschätzungen in den Clustern erfolgt, die aus dem Verfahren zur automatischen Modalerkennung resultieren, wobei MAC $(\Phi_{i,j}, \Phi_{i,l})$ ein dimensionsloser Korrelationskoeffizient zwischen den Modalformen der die i-ten Modeschätzung der modalen Ordnung j und der vorherigen modalen Ordnung l ist:

$$MAC(\Phi_{i,j},\Phi_{i,l}) = \frac{\left|\Phi_{i,j}^{H}\Phi_{i,l}\right|}{\left\|\Phi_{i,j}\right\|_{2}^{2}\left\|\Phi_{i,l}\right\|_{2}^{2}}.$$

12. Das Verfahren nach irgendeinem der vorherigen Ansprüche, wobei die Abstandsfunktion D, die in dem Verfahren zur automatischen Moduserkennung angewendet wird, nicht von MAC $(\Phi_{i,j}, \Phi_{i,l})$ abhängt, und ein dimensionsloser Korrelationskoeffizient zwischen den Modalformen der i-ten Modeschätzung der modalordnung j und der vorherigen modalen Ordnung l ist:

$$MAC(\Phi_{i,j},\Phi_{i,l}) = \frac{\left|\Phi_{i,j}^{H}\Phi_{i,l}\right|}{\left\|\Phi_{i,j}\right\|_{2}^{2}\left\|\Phi_{i,l}\right\|_{2}^{2}}.$$

13. Das Verfahren nach irgendeinem der vorherigen Ansprüche, wobei das Signal ein elektrisches Signal ist, das von einem Sensor, der an einer drehenden Maschine montiert ist, erzeugt wird.

14. Das Verfahren nach irgendeinem der vorherigen Ansprüche, wobei das Signal vor Ausführen der Modalanalyse vorverarbeitet wird und wobei die Vorverarbeitung die Reduktion von harmonischen Spitzen, die über eine Vielzahl von Linien in dem Spektrum des Signals auf eine einzige Linie verteilt sind, umfasst.

15. Das Verfahren nach Anspruch 2, wobei das Verfahren auf ein Signal, das von einem Messgeber (100) erlangt wird, angewendet wird und von einem Signalprozessor, der in den Messgeber (100) eingebettet ist, ausgeführt wird.

**Revendications**

1. Procédé d'identification de composantes de fréquence spécifiques dans un signal, le procédé comprenant :

l'obtention du signal dans le domaine temporel,
la réalisation d'une analyse modale sur le signal par entrée du signal dans un estimateur modal, dans lequel un spectre de fréquence du signal est traité comme une fonction de réponse en fréquence d'un système virtuel, ainsi identifiant une pluralité d'estimations de mode du système virtuel, pour une pluralité d'ordres modaux,
l'application d'un procédé pour la détection automatique de modes physiques à partir de la pluralité d'estimations de mode pour la pluralité d'ordres modaux, chaque estimation de mode étant définie par une valeur propre et une forme de mode, comprenant les étapes de :

a) définition d'un nombre N de valeurs centroïdes de N partitions, sur la base d'une ou plusieurs caractéristiques des estimations de mode,
b) distribution des estimations de mode entre les N partitions selon un algorithme de partitionnement non hiérarchique sur la base desdites une ou plusieurs caractéristiques,
c) définition d'une fonction de distance D qui exprime une comparaison entre une estimation de mode d'un ordre modal donné et la même estimation de mode d'un ordre modal inférieur, et définition d'une valeur seuil Dt pour ladite fonction de distance,
d) calcul de la distance entre des paires de partitions multiples, comme étant la fonction de distance entre des estimations représentatives de mode des N partitions,
e) si les distances entre les paires de partitions multiples sont supérieures ou égales au seuil Dt, conclure que chaque partition est associée à un mode particulier et passer à l'étape g)
f) si la distance entre une ou plusieurs paires de partitions est au-dessous du seuil, définition d'un centroïde commun pour lesdites paires de partitions et répétition des étapes b), d) et e) avec une quantité de partitions inférieure à N,
g) calcul d'une métrique pour le caractère fallacieux pour toutes les estimations de mode dans les partitions, et décision au moins sur la base de la métrique du fait qu'une partition est associée à un mode physique ou à un mode non physique,

dans lequel un mode est sélectionné comme étant physique lorsque les valeurs de la métrique de toutes les estimations de mode dans une partition sont au-dessus d'un seuil, et
la sélection d'un ou plusieurs modes physiques, correspondant auxdites composantes de fréquence.

2. Procédé d'élimination de composantes de fréquence d'un signal, le procédé comprenant les étapes de :

application du procédé pour identifier des composantes de fréquence spécifiques dans un signal selon la revendication 1 audit signal pour obtenir un ou plusieurs modes physiques ; et
élimination automatique de composantes de fréquence du signal, comprenant :

la synthèse des un ou plusieurs modes physiques sélectionnés, ainsi obtenant un ou plusieurs signaux synthétisés dans le domaine temporel,
la soustraction des signaux de domaine temporel synthétisés du signal original, ainsi obtenant un signal nettoyé avec les composantes de fréquence sélectionnées éliminées de celui-ci.

3. Procédé de réalisation d'une analyse modale opérationnelle sur une structure, comprenant les étapes de :

• obtention de signaux dans le domaine temporel, à partir d'une pluralité d'emplacements sur la structure,
• application du procédé selon la revendication 2 aux signaux, de façon à éliminer des composantes de fréquence indésirables du spectre de fréquence de chaque signal, ce qui conduit à un ensemble de données de signaux nettoyés,
• réalisation d'une analyse modale opérationnelle sur la base de l'ensemble de données de signaux nettoyés.

**4.** Procédé selon l'une quelconque des revendications précédentes, dans lequel la décision sur le fait qu'un mode est un mode physique est en outre prise sur la base du nombre d'estimations de mode dans une partition, et dans lequel une partition est associé à un mode physique lorsque le nombre d'estimations de mode dans le groupe est supérieur ou égal à une valeur donnée.

**5.** Procédé selon l'une quelconque des revendications précédentes, dans lequel les une ou plusieurs caractéristiques des estimations de mode expriment une comparaison entre une estimation de mode d'un ordre modal donné et la même estimation de mode d'un ordre modal précédent ou suivant.

**6.** Procédé selon la revendication 5, dans lequel les caractéristiques sont choisies dans le groupe constitué de :

• la distance entre les valeurs propres de la $i^{\text{ème}}$ estimation de mode de l'ordre modal j et de l'ordre modal précédent l :

$$d(\lambda_{i,j}, \lambda_{i,l}) = \frac{\left|\lambda_{i,j} - \lambda_{i,l}\right|}{\max(\left|\lambda_{i,j}\right|, \left|\lambda_{i,l}\right|)}$$

• la distance entre les fréquences propres de la $i^{\text{ème}}$ estimation de mode de l'ordre modal j et de l'ordre modal précédent l :

$$d(f_{i,j}, f_{i,l}) = \frac{\left|f_{i,j} - f_{i,l}\right|}{\max(\left|f_{i,j}\right|, \left|f_{i,l}\right|)}$$

• la distance entre les rapports d'amortissement de la $i^{\text{ème}}$ estimation de mode de l'ordre modal j et de l'ordre modal précédent l :

$$d(\xi_{i,j}, \xi_{i,l}) = \frac{\left|\xi_{i,j} - \xi_{i,l}\right|}{\max(\left|\xi_{i,j}\right|, \left|\xi_{i,l}\right|)}$$

• le coefficient de corrélation non dimensionnel entre les formes de mode de la $i^{\text{ème}}$ estimation de mode de l'ordre modal j et de l'ordre modal précédent l :

$$MAC(\Phi_{i,j}, \Phi_{i,l}) = \frac{\left|\Phi_{i,j}^{H} \Phi_{i,l}\right|}{\left\|\Phi_{i,j}\right\|_2^2 \left\|\Phi_{i,l}\right\|_2^2}.$$

**7.** Procédé selon l'une quelconque des revendications précédentes dans lequel la fonction de distance est $D_i(j,l) = d(\lambda_{i,j}, \lambda_{i,l}) + 1 - MAC(\Phi_{i,j}, \Phi_{i,l})$ ou $D_i(j,l) = d(\lambda_{i,j}, \lambda_{i,l})$ , dans lequel $d(\lambda_{i,j}, \lambda_{i,l})$ est la distance entre les valeurs propres de la $i^{\text{ème}}$ estimation de mode de l'ordre modal j et de l'ordre modal précédent l :

$$d(\lambda_{i,j}, \lambda_{i,l}) = \frac{\left|\lambda_{i,j} - \lambda_{i,l}\right|}{\max(\left|\lambda_{i,j}\right|, \left|\lambda_{i,l}\right|)}$$

et dans lequel MAC($\Phi_{i,j},\Phi_{i,l}$) est un coefficient de corrélation non dimensionnel entre les formes de mode de la $i^{\text{ème}}$ estimation de mode de l'ordre modal j et de l'ordre modal précédent l :

$$MAC(\Phi_{i,j},\Phi_{i,l}) = \frac{\left|\Phi_{i,j}^{H}\Phi_{i,l}\right|}{\left\|\Phi_{i,j}\right\|_{2}^{2}\left\|\Phi_{i,l}\right\|_{2}^{2}}.$$

8. Procédé selon l'une quelconque des revendications précédentes, dans lequel le seuil Dt de la fonction de distance est égal à $\mu + 2\sigma$, $\mu$ et $\sigma$ étant respectivement la moyenne et l'écart type de la fonction de distance calculée pour toutes les estimations de mode.

9. Procédé selon l'une quelconque des revendications précédentes, le procédé étant conduit plusieurs fois, chaque fois en utilisant un estimateur modal différent, résultant en la détection de modes physiques détectés automatiquement grâce à l'utilisation d'un ou plusieurs estimateurs modaux.

10. Procédé selon l'une quelconque des revendications précédentes, dans lequel la métrique pour le caractère fallacieux est le coefficient de silhouette.

11. Procédé selon l'une quelconque des revendications précédentes, dans lequel les composantes de fréquence sont des composantes harmoniques du signal et dans lequel la sélection des harmoniques est effectuée sur la base du coefficient d'amortissement et/ou de la valeur MAC($\Phi_{i,j},\Phi_{i,l}$) d'estimations de mode dans les partitions résultant du procédé de détection automatique de mode, dans lequel MAC($\Phi_{i,j},\Phi_{i,l}$) est un coefficient de corrélation non dimensionnel entre les formes de mode de la $i^{\text{ème}}$ estimation de mode de l'ordre modal j et de l'ordre modal précédent l :

$$MAC(\Phi_{i,j},\Phi_{i,l}) = \frac{\left|\Phi_{i,j}^{H}\Phi_{i,l}\right|}{\left\|\Phi_{i,j}\right\|_{2}^{2}\left\|\Phi_{i,l}\right\|_{2}^{2}}.$$

12. Procédé selon l'une quelconque des revendications précédentes, dans lequel la fonction de distance D appliquée dans le procédé de détection automatique de mode ne dépend pas de MAC($\Phi_{i,j},\Phi_{i,l}$), étant un coefficient de corrélation non dimensionnel entre les formes de mode de la $i^{\text{ème}}$ estimation de mode de l'ordre modal j et de l'ordre modal précédent l :

$$MAC(\Phi_{i,j},\Phi_{i,l}) = \frac{\left|\Phi_{i,j}^{H}\Phi_{i,l}\right|}{\left\|\Phi_{i,j}\right\|_{2}^{2}\left\|\Phi_{i,l}\right\|_{2}^{2}}.$$

13. Procédé selon l'une quelconque des revendications précédentes, dans lequel le signal est un signal électrique généré par un capteur monté sur une machine rotative.

14. Procédé selon l'une quelconque des revendications précédentes, dans lequel le signal est prétraité avant d'effectuer l'analyse modale et dans lequel le prétraitement comprend la réduction de pics harmoniques répartis sur une pluralité de raies dans le spectre du signal à une raie unique.

15. Procédé selon la revendication 2, le procédé étant appliqué sur un signal obtenu par un transducteur (100) et conduit par un processeur de signal incorporé dans le transducteur (100).

FIG. 1

FIG. 2a

EP 3 649 568 B1

FIG. 2b

FIG. 2c

FIG. 3

FIG. 4

27

FIG. 5

FIG. 6

FIG. 7a

FIG. 7b

FIG. 7c

FIG. 8a

FIG. 8b

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. DE ROECK ; E. REYNDERS ; J. HOUBRECHTS.** Fully automated (operational) modal analysis. *Mechanical Systems and Signal Processing,* 2012, vol. 29, 228-250
- **PINTELON et al.** Continuous-time Operational Modal Analysis in the presence of harmonic disturbances. *Mechanical Systems and Signal Processing,* 2008, vol. 22, 1017-1035

- **GUILLAUME et al.** Frequency Domain Maximum Likelihood Identification of Sinusoids Applied to Rotating Machinery. *Proceedings of the 18th International Modal Analysis Conference,* 2000, 411-417